# EUROPÄISCHE PATENTANMELDUNG

(11) **EP 4 592 689 A1**
(43) Veröffentlichungstag der Anmeldung: **30.07.2025**
(21) Anmeldenummer: 25152572.1
(22) Anmeldetag: 17.01.2025
(51) Int. Cl.: G01R 19/165

(54) **ÜBER- UND/ODER UNTERSPANNUNGS-PRÜFUNG**

(30) Priorität: 23.01.2024 CH 792024
(71) Anmelder: ELESTA GmbH, 7310 Bad Ragaz (CH)
(72) Erfinder: Möhr, Raphael, 7304 Maienfeld (CH)
(74) Vertreter: Swisspat Riederer Hasler Patentanwälte AG

(57) **Zusammenfassung**

Dargestellt und beschrieben ist ein Verfahren zur Überprüfung der Funktionsfähigkeit der Spannungsüberwachung einer Schaltung (11). Das Verfahren umfasst, dass eine Recheneinheit (19) ein Testsignal an eine Spannungsquelle (13) sendet, welches eine Änderung der Spannung der Spannungsquelle (13) verursacht. Eine Vergleichseinheit (17) vergleicht die Spannung am Ausgang der Spannungsquelle (24) mit einer Referenzspannung und sendet ein Abschaltsignal an einen Schalter (15), wenn die Spannung am Ausgang der Spannungsquelle (13) ausserhalb eines vorbestimmten Toleranzbereichs liegt. Der Schalter (15) unterbricht den Stromdurchfluss bei Erhalt eines Abschaltsignals, wodurch die Spannung nach dem Schalter (15) fällt.

Erfindungsgemäss ist vorgesehen, dass die Recheneinheit (19) die Spannung nach dem Schalter (15) misst und aufgrund dieser Spannung auf die Funktionsfähigkeit der Spannungsüberwachung schliesst.

## Beschreibung

### TECHNISCHES GEBIET DER ERFINDUNG

Die Erfindung betrifft ein Verfahren zur Überprüfung der Funktionsfähigkeit der Spannungsüberwachung einer Schaltung gemäss Anspruch 1 und eine Schaltung gemäss Oberbegriff des Anspruchs 11.

### HINTERGRUND DER ERFINDUNG

Ein typisches Anwendungsgebiet für Verfahren und Schaltungen im Sinne der Erfindung ist die Automatisierungsindustrie. Die Automatisierungstechnik ist ein Teilgebiet des Anlagenbaus und der Ingenieurwissenschaften und betrifft die Automatisierung von technischen Vorgängen in komplexen Maschinen und Anlagen. Elektrische Schaltungen im Sinne der Erfindung betreffen insbesondere Schaltungen für die Überwachung der Systemspannung und zur Unterbrechung der Weiterleitung der Spannung, falls sich diese ausserhalb von definierten Grenzen befindet. Solche Schaltungen zur Überwachung und Unterbrechung der Spannung (oft auch lediglich als «Spannungsüberwachung» bezeichnet) werden beispielsweise dort eingesetzt, wo Überspannung zu einem sicherheitskritischen Systemzustand führt und der stromlose Zustand einen sicheren Systemzustand darstellt. Beispielsweise sind solche elektrische Schaltungen unter anderem für die Überwachung der Systemspannung in unterschiedlichen Betriebsmodi zuständig. Die Folgen einer Fehlfunktion einer solchen Schaltung kann grosse Auswirkungen haben, da die Überwachung und Unterbrechung der Systemspannung («Spannungsüberwachung») nicht mehr sichergestellt wäre. Aufgrund dieser weiten Tragweite der Schaltungs-Funktion, ist die Sicherstellung der zuverlässigen Funktion der Schaltung von grosser Bedeutung, damit gefährliche Situationen vermieden werden können. Da die Sicherstellung der fehlerfreien Funktion oft nicht trivial ist oder nicht in vollem Umfang erfolgen kann, wird üblicherweise auf redundante Schaltungsauslegung gesetzt. Durch Redundanz, bei welcher redundante Schaltungen zur Überwachung und Unterbrechung der Spannung beispielsweise in Serie angeordnet sind, wird die Robustheit der Funktion «Überwachung und Unterbrechung» erhöht. Der Nachteil solch einer Anordnung ist jedoch oft, dass die Schaltungen während dem Betrieb nicht getestet werden. Beispielsweise wird im Stand der Techink die zuverlässige Funktion bzw. die Funktionsfähigkeit der Spannungsüberwachung einer Schaltung durch Redundanz mit zwei Elementen gewährleistet, welche in Serie angeordnet sind. Diese Elemente können je einen Schalter umfassen, welche einen integrierten Abschaltmechanismus aufweisen, der bei einer Spannung ausserhalb des erlaubten System-Spannungsbereichs aktiviert wird. Der Vorteil hierbei ist, dass diese Elemente zur Spannungsüberwachung in der Schaltung redundant sind und bei Ausfall eines Elements zur Spannungsüberwachung ein zweites Element die Aufgabe weiterführen kann. Die Spannungsüberwachung wird allerdings nach einmaliger Inbetriebnahme während dem Betrieb nicht fortwährend auf deren Funktionsfähigkeit überprüft. Deshalb ist diese Anordnung anfällig auf eine Fehlfunktion, welche sich schleichend oder über einen Fehler gemeinsamer Ursache in beiden Spannungsüberwachungen einstellt. Durch die fehlende Kontrolle der Spannungsüberwachung, d.h. eine fehlende Funktionskontrolle der Schaltung zur Überwachung und Unterbrechung der Spannung, liegt keine Information über die Funktionsfähigkeit der Schaltung zu einem beliebigen Zeitpunkt vor.

Des Weiteren sind die Herstellung und der Einbau von zwei Elementen (zwei Schaltungen) zur Spannungsüberwachung im Vergleich zu einem einzelnen Element (einer einzelnen Schaltung) mit fast doppelten Materialkosten und Einbauvolumen verbunden.

### AUFGABE

Die Aufgabe der vorliegenden Erfindung liegt darin, ein Verfahren zur Überprüfung der Funktionsfähigkeit einer Spannungsüberwachung (Schaltung zur Überwachung der Systemspannung mit integrierter Spannungsunterbrechung) zu zeigen, welche eine kostengünstige und platzsparende Umsetzung einer Schaltung ermöglicht.

Des Weiteren soll eine möglichst kostengünstige und platzsparende Schaltung zur Spannungsüberwachung gezeigt werden.

### BESCHREIBUNG

Die Aufgabe wird gelöst mit einem Verfahren mit den Merkmalen des Patentanspruchs 1.

Die Erfindung bezieht sich auf ein Verfahren zur Überprüfung der Funktionsfähigkeit der Spannungsüberwachung einer Schaltung. Das erfindungsgemässe Verfahren und die nachfolgend beschriebene erfindungsgemässe Schaltung zur Überprüfung der Funktionsfähigkeit einer Spannungsüberwachung finden insbesondere Anwendung in der Automatisierungsindustrie.

In einem ersten Schritt sendet eine Recheneinheit ein Testsignal an eine Spannungsquelle, welches eine Änderung der Spannung der Spannungsquelle verursacht. Eine Vergleichseinheit vergleicht die Spannung am Ausgang der Spannungsquelle mit einer Referenzspannung und sendet ein Abschaltsignal an einen Schalter (der im Rahmen der Spannungsüberwachung zum Unterbrechen des Stromflusses vorgesehen ist), wenn die Spannung am Ausgang der Spannungsquelle ausserhalb eines Toleranzbereichs liegt. Der Schalter unterbricht den Stromdurchfluss bei Erhalt eines Abschaltsignals, wodurch die Spannung nach dem Schalter fällt. Das erfindungsgemässe Verfahren zeichnet sich dadurch aus, dass die Recheneinheit die Spannung nach dem Schalter misst und aufgrund dieser Spannung auf die Funktionsfähigkeit der Spannungsüberwachung schliesst.

Das erfindungsgemässe Verfahren ermöglicht durch Einsatz eines Testsignals aus einer Recheneinheit, eine Überprüfung der Funktionsfähigkeit einer Spannungsüberwachung vorzunehmen. Das Testsignal dient zur Erzeugung einer Spannung, die ausserhalb des Toleranzbereichs der Arbeitsspannung liegt und aufgrund dessen einen Unterbruch des Schalters provoziert. Der Unterbruch des Schalters wird durch ein Abschaltsignal einer Vergleichseinheit ausgelöst, das gesandt wird, wenn die Vergleichseinheit feststellt, dass die Spannung am Ausgang der Spannungsquelle ausserhalb des Toleranzbereichs liegt. Somit wird überprüft, ob der Abschaltmechanismus funktioniert und eine Spannungsüberwachung in der Schaltung gewährleistet ist. Mit Hilfe dieses Verfahrens kann in einer Schaltung die Funktionsfähigkeit einer Spannungsüberwachung gewährleistet sein, wobei die Schaltung hierfür keine redundanten Elemente aufzuweisen hat. Durch Verzicht auf Redundanz, d.h. durch die Verwendung der Elemente in einzelner Ausführung in der Schaltung, wird die Schaltung sowohl kostengünstig in der Herstellung als auch platzsparend in der Grösse.

Vorzugsweise verursacht das Testsignal eine Erhöhung oder Reduktion der Spannung der Spannungsquelle. Das Testsignal kann die Spannung der Spannungsquelle erhöhen oder reduzieren, wodurch die Spannung am Ausgang der Spannungsquelle entsprechend verändert wird. Die Systemspannung weist einen Toleranzbereich mit einer unteren und oberen Grenze auf. Aus diesem Grund kann die Überprüfung der Funktionsfähigkeit der Spannungsüberwachung mit einer Reduktion oder einer Erhöhung der Spannung durchgeführt werden.

Die Recheneinheit sendet vorteilhafterweise in regelmässigen Zeitabständen ein Testsignal. Die Überprüfung der Funktionsfähigkeit der Spannungsüberwachung wird durch Senden eines Testsignals von der Recheneinheit gestartet. Die Recheneinheit kann derart eingestellt werden, dass sie in bestimmten und vordefinierten Zeitabständen ein Testsignal an die Spannungsquelle sendet. Dies ermöglicht eine regelmässige Überprüfung der Funktionsfähigkeit der Spannungsüberwachung.

Vorzugsweise liegt der Arbeitsspannungsbereich der Schaltung zwischen 4.5 - 5.5 V, bevorzugt zwischen 4.85 - 5.15 V, wobei der Arbeitsspannungsbereich jenen Bereich definiert, in welchem die Funktion des Systems gewährleistet ist. Damit wird zugleich auch der Einsatzbereich der Schaltung bestimmt.

Die durch das Testsignal geänderte Spannung liegt bevorzugt ausserhalb des Arbeitsspannungsbereichs und innerhalb eines definierten Spannungsbereichs, in welchem keine Überbeanspruchung des Systems stattfindet. Die Aufgabe des Testimpulses ist es, die Spannung ausserhalb des Arbeitsspannungsbereichs zu bringen. Bevorzugt ist die Spannung dabei innerhalb eines definierten Spannungsbereichs, damit die Elemente der Schaltung nicht derart hohen Spannungsunterschieden ausgesetzt sind, dass sie einen Schaden davon tragen können, was wiederum die Lebensdauer der Schaltung reduzieren könnte. Als obere Grenze kann für diesen Spannungsbereich eine Spannung von 6 V vorgesehen sein.

In einer weiteren Ausführungsform liegt der Arbeitsspannungsbereich der Schaltung zwischen 3.0 - 3.6 V, bevorzugt zwischen 3.2 - 3.4 V, wobei der Arbeitsspannungsbereich jenen Bereich definiert, in welchem die Funktion des Systems gewährleistet ist. Auch hier liegt die durch das Testsignal geänderte Spannung bevorzugt ausserhalb des Arbeitsspannungsbereichs und innerhalb eines definierten Spannungsbereichs, wobei als obere Grenze für diesen Spannungsbereich eine Spannung von 4 V vorgesehen sein kann.

Vorzugsweise reduziert die Spannungsquelle eine Versorgungsspannung als Eingangsspannung auf die Systemspannung. Die Spannungsquelle dient in diesem Fall als Spannungswandler. Die Versorgungsspannung kann eine beliebige Spannung sein, die zur Verfügung gestellt wird. Solange die Spannungsquelle die Spannung auf die Systemspannung reduziert, ist die Funktionsfähigkeit der Schaltung gegeben.

In einer weiteren bevorzugten Ausführung liegt die Versorgungsspannung zwischen 10 V und 50 V, vorzugsweise zwischen 18 V und 30 V. Somit deckt die Versorgungsspannung den Bereich ab, welcher bei Geräten in der Automatisation verwendet wird.

Vorzugsweise bleibt der Betrieb der Schaltung während dem Versand eines Testsignals und dem möglichen Abschalten des Schalters durch eine zweite Spannungsquelle aufrechterhalten. Die zweite Spannungsquelle stellt sicher, dass die Spannung am Ausgang der Schaltung nicht auf Null sinkt und dass somit die Schaltung weiterhin im Betrieb bleibt.

Die zweite Spannungsquelle umfasst bevorzugt Kondensatoren. Kondensatoren können während der Überprüfung der Funktionsfähigkeit der Spannungsüberwachung in der Schaltung als Spannungsquelle dienen, da sie elektrische Energie speichern können. Während dem normalen Betrieb werden die Kondensatoren jeweils aufgeladen und können bei Bedarf durch Entladen der Kondensatoren der Schaltung Strom zur Verfügung stellen.

Ein weiterer Aspekt der Erfindung betrifft eine Schaltung zur Überprüfung der Funktionsfähigkeit einer Spannungsüberwachung. Die Schaltung umfasst eine Spannungsquelle, welche eine einstellbare Ausgangsspannung zur Verfügung stellt, und einen Schalter zum Unterbrechen des Stromdurchflusses. Des Weiteren umfasst die Schaltung eine Vergleichseinheit, welche die Spannung am Ausgang der Spannungsquelle mit einer Referenzspannung vergleicht und aufgrund des Vergleichsergebnisses ein Abschaltsignal an den Schalter senden kann. Eine Recheneinheit misst die Spannung am Ausgang des Schalters. Die Recheneinheit ist vorgesehen, ein Testsignal an die Spannungsquelle zu senden, um die Spannung der Spannungsquelle zu verändern und um mit der Spannung am Ausgang des Schalters die Funktionsfähigkeit der Spannungsüberwachung zu prüfen.

Vorzugsweise weist die Spannung am Ausgang der Spannungsquelle einen Toleranzbereich auf und die Vergleichseinheit sendet ein Abschaltsignal an den Schalter, wenn die gemessene Spannung am Ausgang der Spannungsquelle ausserhalb dieses Toleranzbereichs liegt.

Vorteilhafterweise ist eine zweite Spannungsquelle, insbesondere Kondensatoren, vorgesehen, die bei Unterbruch des Stromdurchflusses durch den Schalter dem Ausgang der Schaltung Strom liefert und die fortgehende Funktion der Schaltung gewährleistet.

Bevorzugt ist eine Schutzvorrichtung vor Rückspeisung zwischen der zweiten Spannungsquelle und dem Schalter derart angeordnet ist, dass der Strom nie von der zweiten Spannungsquelle zum Schalter fliessen kann und die Messung der Recheneinheit durch die zweite Spannungsquelle nicht beeinflusst wird. Vorzugsweise ist die Schutzvorrichtung vor Rückspeisung durch eine Halbleiterschaltung, insbesondere eine Diode, gebildet.

Genannte optionale Merkmale können in beliebiger Kombination verwirklicht werden, soweit sie sich nicht gegenseitig ausschliessen. Insbesondere dort wo bevorzugte Bereiche angegeben sind, ergeben sich weitere bevorzugte Bereiche aus Kombinationen der in den Bereichen genannten Minima und Maxima.

Weitere Vorteile und Merkmale der Erfindung ergeben sich aus der nachfolgenden Beschreibung von Ausführungsbeispielen der Erfindung unter Bezugnahme auf schematische Darstellungen.

### KURZBESCHREIBUNG DER FIGUREN

Es zeigen in nicht massstabsgetreuer, schematischer Darstellung:
- Figur 1:: einen Schaltplan einer erfindungsmässigen Schaltung;
- Figur 2:: ein Diagramm mit zeitlichem Ablauf der Spannung an vier Stellen der Schaltung beim Senden eines Testsignals;

### DETAILIERTE BESCHREIBUNG DER FIGUREN

Im Folgenden stehen gleiche Bezugsziffern für gleiche oder funktionsgleiche Elemente in unterschiedlichen Figuren. Ein zusätzlicher Apostroph kann zur Unterscheidung gleichartiger bzw. funktionsgleicher oder funktionsähnlicher Elemente in einer weiteren Ausführung dienen.

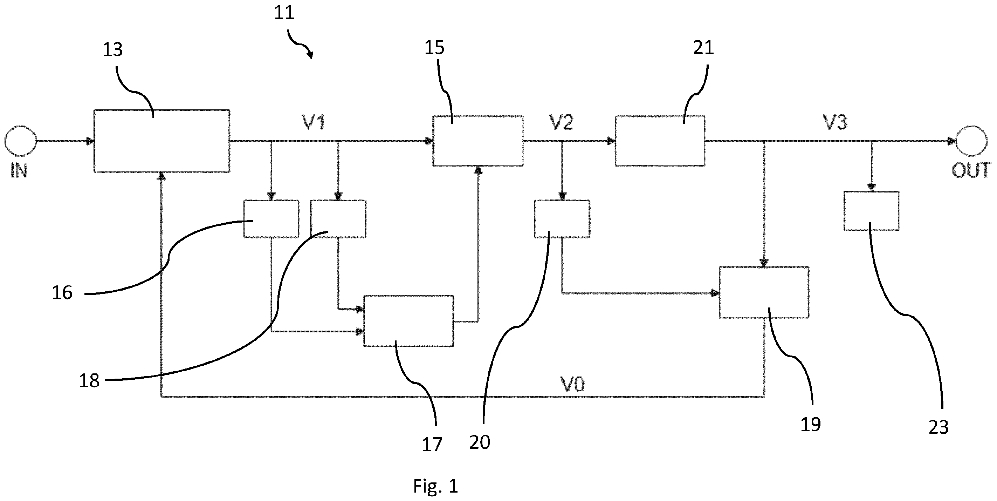

Figur 1 zeigt einen Schaltplan einer erfindungsmässigen Schaltung 11 mit einer Abschaltfunktion bei Über- oder Unterspannung. Die Versorgungsspannung ist an der veränderbaren Spannungsquelle 13 angelegt. Die Spannungsquelle 13 wandelt die Versorgungsspannung in eine tiefere Systemspannung um, welche durch die nachfolgende Schaltung 11 mit einem Schalter 15 überwacht wird. Dabei verfügt die Spannungsquelle 13 über die Eigenschaft, die Systemspannung variieren zu können. Die Änderung der Systemspannung kann in voreingestellten Intervallen oder durch externen Input ausgelöst werden. Zwischen der Spannungsquelle 13 und dem Schalter 15 ist eine Vergleichseinheit 17 eingebaut. Die Vergleichseinheit 17 vergleicht die aktuelle Spannung am Ausgang der Spannungsquelle, welche mittels einer ersten Spannungsrücklesung 16 an die Vergleichseinheit 17 weitergeleitet wird, und vergleicht diese mit einer Referenzspannung aus einer Referenzspannungsquelle 18. Falls die Abweichung grösser ist als eine erlaubte Toleranz, liegt eine Überspannung oder Unterspannung vor und die Vergleichseinheit 17 sendet ein Abschaltsignal an den Schalter 15. Auf den Schalter 15 folgen in der Schaltung 11 eine Recheneinheit 19 und eine Diode 21. Die Diode 21 ist vorgesehen, den Strom einseitig vom Schalter 15 zum Ausgang der Schaltung zu übertragen. Die Recheneinheit 19 erhält die Spannung am Austritt des Schalters mittels einer zweiten Spannungsrücklesung 20. Aufgrund der Spannung am Austritt des Schalters kann die Recheneinheit 19 feststellen, ob die Spannungsüberwachung der Schaltung 11 funktioniert. Zugleich ist die Recheneinheit 19 mit der Spannungsquelle 13 verbunden. Die Recheneinheit 19 initiiert den Test zur Spannungsüberwachung und sendet hierfür ein Testsignal an die Spannungsquelle 13, wodurch die Spannung der Spannungsquelle verändert wird. Falls die Spannung oberhalb oder unterhalb des Toleranzbereichs der Systemspannung liegt, erzeugt die Vergleichseinheit 17 ein Abschaltsignal für den Schalter 15, woraufhin der Schalter 15 den Stromdurchfluss unterbricht. Die Spannung nach dem Schalter fällt schnell ab, da die Diode 21 den Zugang des Stromes aus dem Schaltungs-Ausgang zum Schalter hin blockiert. Nach der Diode 21 ist eine weitere Spannungsquelle 23 in Form von Kondensatoren angebracht. Der Strom in dieser zweiten Spannungsquelle 23 fängt an zu fliessen, wenn die Spannung vor und somit auch nach der Diode 21 reduziert wird. Die zweite Spannungsquelle 23 sorgt somit für einen stabilen Zustand der Spannung nach der Diode 21 und am Ausgang der Schaltung, wodurch allgemein die fortgehende Funktion der Schaltung 11 beim Durchführen eines Tests nicht unterbrochen wird. Aufgrund der Eigenschaft der Diode 21, nur in eine Richtung den Strom fliessen zu lassen, bleibt die Spannung am Ausgang des Schalters, welche von der Recheneinheit 19 gemessen wird, unbeeinflusst von der zweiten Spannungsquelle 23.

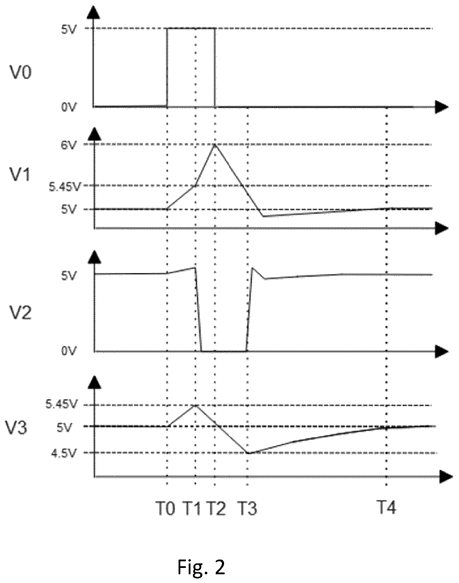

In Figur 2 ist ein zeitlicher Ablauf der Spannungen an vier verschiedenen Punkten in der Schaltung (V0, V1, V2 und V3) gezeigt, wobei die Diagramme derart übereinander dargestellt sind, dass die Horizontalachse jeweils dieselbe zeitliche Achse in allen Diagrammen bildet. Das erste Diagramm zeigt den zeitlichen Verlauf der Spannung an der Verbindung zwischen der Recheneinheit 19 und der ersten Spannungsquelle 13, welche durch die erste Spannungsrücklesung 16 erfasst wird. Im zweiten Diagramm ist der Verlauf der Spannung zwischen der ersten Spannungsquelle 13 und dem Schalter 15 dargestellt. Die Spannung am Ausgang des Schalters 15, welche durch die zweite Spannungsrücklesung 20 erfasst wird, ist im dritten Diagramm gezeigt. Das vierte Diagramm wiederum zeigt den Verlauf der Spannung am Ausgang der Schaltung 11. Zum Zeitpunkt t0 wird der Test zur Spannungsüberwachung durch die Recheneinheit 19 ausgelöst, indem ein Signal an die erste Spannungsquelle 13 gesendet wird. Das Signal bewirkt in diesem Fall eine Erhöhung der Spannung am Ausgang der Spannungsquelle 13. Diese Spannung wird durch die Vergleichseinheit 17 fortwährend überwacht und kontrolliert. Als Folge der Spannungserhöhung am Ausgang der Spannungsquelle steigt auch die Spannung nach dem Schalter. Die Spannung am Ausgang der Spannungsquelle erreicht zum Zeitpunkt t1 einen Wert, welcher nicht mehr im Toleranzbereich der Arbeitsspannung liegt und welcher durch die Vergleichseinheit 17 detektiert wird. Die Vergleichseinheit 17 sendet daraufhin ein Abschaltsignal an den Schalter 15, woraufhin der Schalter 15 den Stromdurchfluss unterbricht. Innerhalb einer sehr kurzen Zeit sinkt die Spannung nach dem Schalter auf Null. Die Recheneinheit 19, welche den Test ausgelöst und die Spannungserhöhung bewirkt hat, misst die gesunkene Spannung am Ausgang des Schalters und merkt, dass der Test damit erfolgreich war. Nach der Detektion der erwarteten Spannungsreduktion durch die Recheneinheit 19 wird das Senden des Testsignals durch die Recheneinheit 17 an die erste Spannungsquelle 13 zum Zeitpunkt t2 gestoppt. Durch den Wegfall des Testsignals wird die Spannung an der Spannungsquelle 13 wieder reduziert. Die trotz des unterbrochenen Schalters weiterhin angestiegene Spannung vor dem Schalter bis zum Zeitpunkt t2 wird nach Wegfall des Testsignals reduziert. Wenn die Spannung vor dem Schalter, welche durch die Vergleichseinheit 17 kontinuierlich kontrolliert wird, unter einen bestimmten Wert fällt und somit wieder innerhalb des Toleranzbereichs der Arbeitsspannung liegt, sendet die Vergleichseinheit 17 zum Zeitpunkt t3 dem Schalter 15 das Signal zum Aufheben des Unterbruchs des Stromdurchflusses. Da die Spannung vor dem Schalter stets einen erhöhten Wert hat, steigt die Spannung am Ausgang des Schalters nach Aufheben des Unterbruchs auch rasch an, so dass innerhalb einer kurzen Zeit nach t3 die Spannung am Ausgang des Schalters auf einem ähnlichen Niveau ist wie vor dem Unterbruch. Im Gegensatz zum Zustand vor dem Unterbruch nimmt die Spannung am Eingang und somit auch am Ausgang des Schalters ab und nähert sich ungefähr der Systemspannung an. Die Spannung am Ausgang der Schaltung, deren Verlauf im vierten Diagramm gezeigt ist, steigt nach dem Senden des Testsignals (t0) ebenfalls bis zum Unterbruch des Schalters (t1) an. Im Gegensatz zur Spannung nach dem Schalter sinkt die Spannung am Ausgang der Schaltung nach t1 nicht schlagartig auf Null, sondern nimmt langsam ab. Die Ursache für die langsame Abnahme der Spannung ist eine zweite Spannungsquelle 23 in Form von Kondensatoren, welche am Ausgang der Schaltung angeordnet ist und eine bestimmte Stromzufuhr im Ausgang der Schaltung gewährleistet, wenn der Stromdurchfluss durch den Schalter 15 unterbrochen ist. Der Strom der zweiten Spannungsquelle 23 kann aufgrund der Diode zwischen dem Ausgang der Schaltung und dem Schalter die Spannung am Ausgang des Schalters nicht beeinflussen. Die Entladung der Kondensatoren findet bis zum Zeitpunkt t3 statt, wonach der Strom wieder über den Schalter fliessen kann. Das Erreichen der Spannung am Ausgang der Schaltung 11 ungefähr zur Systemspannung benötigt vergleichsweise am längsten, da gleichzeitig die Kondensatoren aufgeladen werden und ein Teil des Stroms hierfür verwendet wird.

Während die Erfindung vorstehend unter Bezugnahme auf spezifische Ausführungsformen beschrieben wurde, ist es offensichtlich, dass Änderungen, Modifikationen, Variationen und Kombinationen ohne vom Erfindungsgedanken abzuweichen gemacht werden können.

### BEZUGSZEICHENLISTE:

- 11: Schaltung
- 13: Erste Spannungsquelle
- 15: Schalter
- 16: Erste Spannungsrücklesung
- 17: Vergleichseinheit
- 18: Referenzspannungsquelle
- 19: Recheneinheit
- 20: Zweite Spannungsrücklesung
- 21: Diode
- 23: Zweite Spannungsquelle

## Patentansprüche

1. Verfahren zur Überprüfung der Funktionsfähigkeit der Spannungsüberwachung einer Schaltung 11 mit folgenden Schritten;
eine Recheneinheit 19 sendet ein Testsignal an eine erste Spannungsquelle 13, welches eine Änderung der Spannung der Spannungsquelle 13 verursacht,
eine Vergleichseinheit 17 vergleicht die Spannung am Ausgang der Spannungsquelle 13 mit einer Referenzspannung und sendet ein Abschaltsignal an einen Schalter 15, wenn die Spannung am Ausgang der Spannungsquelle 13 ausserhalb eines Toleranzbereichs liegt,
der Schalter 15 unterbricht den Stromdurchfluss bei Erhalt eines Abschaltsignals, wodurch die Spannung nach dem Schalter 15 fällt,
**dadurch gekennzeichnet, dass**
die Recheneinheit 19 die Spannung nach dem Schalter 15 misst und aufgrund dieser Spannung auf die Funktionsfähigkeit der Spannungsüberwachung schliesst.

2. Verfahren nach Anspruch 1, **dadurch gekennzeichnet, dass** das Testsignal eine Erhöhung oder Reduktion der Spannung der Spannungsquelle 13 verursacht.

3. Verfahren nach Anspruch 1, **dadurch gekennzeichnet, dass** die Recheneinheit 19 in regelmässigen Zeitabständen ein Testsignal sendet.

4. Verfahren nach Anspruch 1, **dadurch gekennzeichnet, dass** der Arbeitsspannungsbereich der Schaltung
• zwischen 4.5 - 5.5 V, vorzugsweise zwischen 4.85 - 5.15 V, oder
• zwischen 3.0 - 3.6 V, vorzugsweise zwischen 3.2 - 3.4 V,
liegt, wobei der Arbeitsspannungsbereich jenen Bereich definiert, in welchem die Funktion des Systems gewährleistet ist.

5. Verfahren nach Anspruch 1, **dadurch gekennzeichnet, dass** die durch das Testsignal geänderte Spannung ausserhalb des Arbeitsspannungsbereich und innerhalb eines definierten Spannungsbereichs, in welchem keine Überbeanspruchung des Systems stattfindet.

6. Verfahren nach Anspruch 1, **dadurch gekennzeichnet, dass** die maximale Spannung zur Gewährleistung der Funktion der Spannungsüberwachung zwischen etwa 5.5 - 6 V oder zwischen 3.6 - 4 V liegt.

7. Verfahren nach Anspruch 1, **dadurch gekennzeichnet, dass** die Spannungsquelle 13 eine Versorgungsspannung als Eingangsspannung auf die Systemspannung reduziert.

8. Verfahren nach Anspruch 1, **dadurch gekennzeichnet, dass** die Versorgungsspannung zwischen 10 V und 50 V, vorzugsweise zwischen 18 V und 30 V, liegt.

9. Verfahren nach Anspruch 1, **dadurch gekennzeichnet, dass** der Betrieb der Schaltung 11 während dem Versand eines Testsignals und dem möglichen Abschalten des Schalters 15 durch eine zweite Spannungsquelle 23 aufrechterhalten bleibt.

10. Verfahren nach Anspruch 1, **dadurch gekennzeichnet, dass** die zweite Spannungsquelle 23 Kondensatoren umfasst.

11. Eine Schaltung 11 zur Überprüfung der Funktionsfähigkeit einer Spannungsüberwachung umfasst
eine Spannungsquelle 13, welche eine einstellbare Ausgangsspannung zur Verfügung stellt,
einen Schalter 15 zum Unterbrechen des Stromdurchflusses,
eine Vergleichseinheit 17, welche die Spannung am Ausgang der Spannungsquelle 13 mit einer Referenzspannung vergleicht und aufgrund des Vergleichsergebnisses ein Abschaltsignal an den Schalter 15 senden kann,
eine Recheneinheit 19, welche die Spannung am Ausgang des Schalters 15 misst, **dadurch gekennzeichnet, dass**
die Recheneinheit 19 vorgesehen ist, ein Testsignal an die Spannungsquelle 13 zu senden, um die Spannung der Spannungsquelle 13 zu verändern und um mit der Spannung am Ausgang des Schalters 15 die Funktionsfähigkeit der Spannungsüberwachung zu prüfen.

12. Schaltung nach Anspruch 11, **dadurch gekennzeichnet, dass** die Spannung am Ausgang der Spannungsquelle 13 einen Toleranzbereich aufweist und die Vergleichseinheit 17 ein Abschaltsignal an den Schalter 15 sendet, wenn die gemessene Spannung am Ausgang der Spannungsquelle 13 ausserhalt dieses Toleranzbereichs liegt.

13. Schaltung nach Anspruch 11, **dadurch gekennzeichnet, dass** eine zweite Spannungsquelle 23, insbesondere Kondensatoren, vorgesehen ist, welche bei Unterbruch des Stromdurchflusses durch den Schalter 15 dem Ausgang der Schaltung Strom liefert und die fortgehende Funktion der Schaltung 11 gewährleistet.

14. Schaltung nach Anspruch 11, **dadurch gekennzeichnet, dass** eine Schutzvorrichtung vor Rückspeisung zwischen der zweiten Spannungsquelle 23 und dem Schalter 15 derart angeordnet ist, dass der Strom nie von der zweiten Spannungsquelle 23 zum Schalter 15 fliessen kann und die Messung der Recheneinheit nicht durch die zweite Spannungsquelle 23 beeinflusst wird.

15. Schaltung nach Anspruch 11, **dadurch gekennzeichnet, dass** die Schutzvorrichtung vor Rückspeisung durch eine Halbleiterschaltung, insbesondere eine Diode 21, gebildet ist.
